# EUROPEAN PATENT APPLICATION

(11) **EP 1 746 726 A1**
(43) Date of publication of application: **24.01.2007**
(21) Application number: 06253780.8
(22) Date of filing: 19.07.2006
(51) Int. Cl.: H03K 17/96

(54) **Device having multiple conductive contact switches**

(30) Priority: 20.07.2005 US 184890
(71) Applicant: EWIG INDUSTRIES MACAO COMMERCIAL OFFSHORE LIMITED, Macau (CN)
(72) Inventor: Chu, Luk Wah Jackson, Macau (CN)
(74) Representative: Jenkins, Richard Gavin

(57) **Abstract**

A device such as a handheld calculator, mobile telephone or remote control unit having a number of input keys.
Each key has an electrically conductive exposed surface to be touched by a user. The device includes a discrete oscillator in circuit with each key for generating an AC voltage. Capacitance of the key changes when touched by a user, changing the AC voltage. A switch circuit responds to the AC voltage change.

## Description

### Background of the Invention

The present invention relates to the device which might otherwise have a plurality of pushbuttons such as handheld calculators, telephones, PDAs, music players, remote controls, keyboards and the like. More particularly, although not exclusively, the invention relates to an improvement over the pushbuttons or keys of such devices.

The keys of such known devices are usually mechanical pushbuttons comprising an electrical contact beneath an actuator. A number of electrical contacts are often provided on a PCB. Such keys are prone to wear and resultant unreliability. They are also prone to the ingress of dust and liquid.

### Objects of the Invention

It is an object of the present invention to overcome or substantially ameliorate at least one of the above disadvantages.

### Disclosure of the Invention

There is disclosed herein a device comprising a plurality of input keys, wherein each key comprises an electrically conductive exposed surface to be touched by a user, a discrete oscillator in circuit with each key for providing an AC voltage, and wherein capacitance of said key changes when touched by a user thereby changing said AC voltage, and switching means responsive to said AC voltage change.

Preferably, the capacitance of said key decreases when touched by a user.

Preferably, the oscillator generates a square wave.

Preferably, the device further comprises a transistor having a gate receiving the square wave and a drain with a voltage controlled by the square wave.

Preferably, the device further comprises a peak detector circuit and a Schmitt trigger circuit.

### Brief Description of the Drawings

A preferred form of the present invention will now be described by way of example with reference to the accompanying drawings, wherein:
Fig. 1 is a schematic front elevation of a handheld device having a number of input keys, and
Fig. 2 is a schematic circuit diagram associated with a single key of a multiple key device.

### Description of the Preferred Embodiment

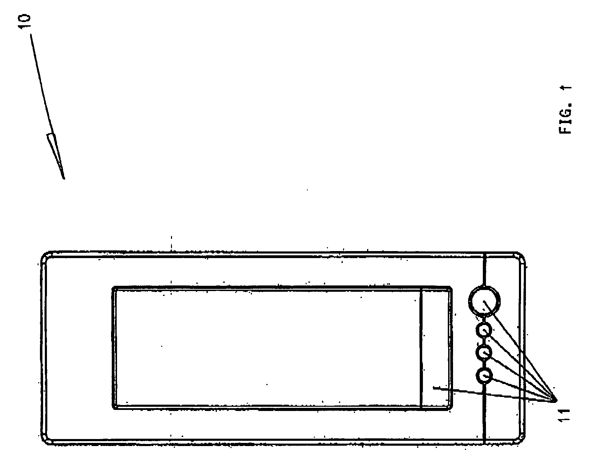

In Fig. 1 of the accompanying drawings there is depicted schematically a handheld electronic device 10 having a plurality of input pads 11. The input pads are electrically conductive and might have a contact surface of metal such as nickel plating over plastic or metal.

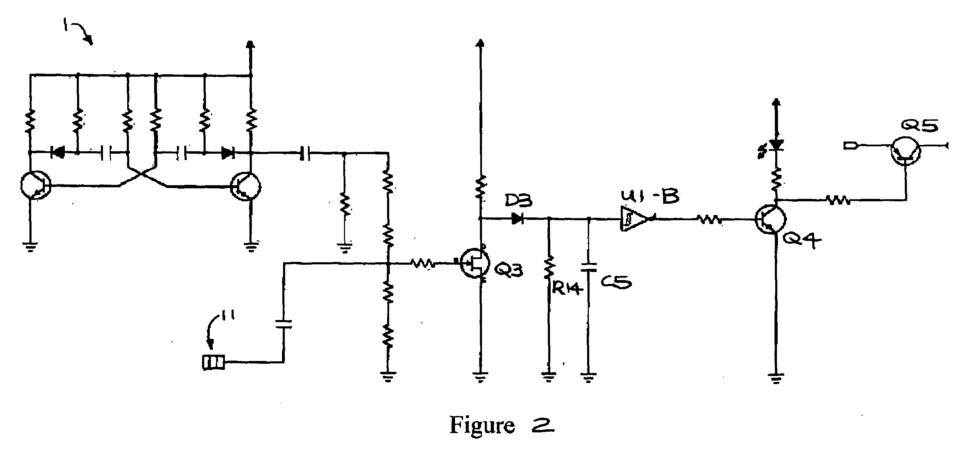

Fig. 2 shows a typical circuit associated with a single one of the keys 11 to control the ON/OFF status of a transistor. Important components of the circuit include an oscillator 1, a transistor Q3, a peak detector circuit formed by a diode D3, a resistor R14, a capacitor C5, a Schmitt trigger IC U1-B, and a transistor Q4.

When a user's finger is not in contact with the keypad 11, the oscillator generates a 120 kHz (typically) square wave, which is passed to the gate of Q3. The square wave controls a voltage of the drain of Q3. The square wave will swing at the drain of Q3. The signal is then passed through the peak detector circuit. The voltage at this detector is sufficiently high to drive the Schmitt trigger IC to be low at its output. Thus the output formed by Q4 and Q5 is off.

When the user's finger is in contact with the pad, the capacitance of the pad is increased. This reduces the AC voltage generated by the oscillator to the gate of Q3, resulting in a decrease of AC voltage at the drain. The peak detector circuit outputs a voltage below the threshold of the Schmitt trigger IC U1-B which outputs at high. The output formed by Q4 and Q5 is then on.

The circuit of Fig. 2 is repeated for each pad of the device.

It should be appreciated that modifications and alterations obvious to those skilled in the art are not be considered as beyond the scope of the present invention. For example, circuit details may be changed without departing from the scope of the invention.

## Claims

1. A device comprising a plurality of input keys, wherein each key comprises an electrically conductive exposed surface to be touched by a user, a discrete oscillator in circuit with each key for providing an AC voltage, and wherein capacitance of said key changes when touched by a user thereby changing said AC voltage, and switching means responsive to said AC voltage change.

2. The device of Claim 1, wherein the capacitance of said key decreases when touched by a user.

3. The device of Claim 1, wherein the oscillator generates a square wave.

4. The device of Claim 3, further comprising a transistor having a gate receiving the square wave and a drain with a voltage controlled by the square wave.

5. The device of Claim 4, further comprising a peak detector circuit and a Schmitt trigger circuit.
